(19) Europäisches Patentamt

European Patent Office

Office européen des brevets

(11) Publication number : **0 264 939 B1**

# (12) EUROPEAN PATENT SPECIFICATION

(45) Date of publication of patent specification :
05.06.91 Bulletin 91/23

(51) Int. Cl.⁵ : **H05K 3/34**

(21) Application number : **87115482.9**

(22) Date of filing : **22.10.87**

(54) **Solder flux, solder paste, and soldering using solder paste.**

(30) Priority : **23.10.86 JP 250756/86**

(43) Date of publication of application :
**27.04.88 Bulletin 88/17**

(45) Publication of the grant of the patent :
**05.06.91 Bulletin 91/23**

(84) Designated Contracting States :
**DE FR GB**

(56) References cited :
**EP-A- 0 164 456**
**GB-A- 2 096 036**

(73) Proprietor : **FUJITSU LIMITED**
**1015, Kamikodanaka Nakahara-ku**
**Kawasaki-shi Kanagawa 211 (JP)**

(72) Inventor : **Ochiai, Masayuki FUJITSU LIMITED**
**Patent Dept.**
**Kosugi Fujitsu Building 1812-10 Shimonumabe**
**Nakahara-ku Kawasaki-shi Kanagawa 211**
**(JP)**

(74) Representative : **Sunderland, James Harry et al**
**HASELTINE LAKE & CO Hazlitt House 28**
**Southampton Buildings Chancery Lane**
**London WC2A 1AT (GB)**

## Description

The present invention relates to solder flux solder paste, and soldering using solder paste, for example a soldering method for mounting electronic components on a printed circuit board using solder paste patterned on the circuit board.

Recently, electronic components, including semiconductor chips, have been mounted on printed circuit boards by soldering using solder paste. Solder paste is patterned on printed circuit boards using various thick film circuit technologies, such as silk screen printing, for example. After patterning of the paste, circuit elements are positioned at respective positions at which they are to be soldered, and the printed circuit boards heated in an oven to solder the circuit elements.

It is desirable to have available several kinds of solder paste including solder alloy powders having different melting points. These different pastes are properly used to solder various circuit elements onto circuit boards. In particular, it is necessary to use a low temperature solder paste for soldering semiconductor chips, in order to avoid deterioration of the chips. Usually, semiconductor chips are soldered using a low temperature solder paste after all other circuit elements, such as capacitors or resistors, have been mounted. Such a method of soldering, utilizing differences of melting points of solders is known in the art as step soldering.

Solder paste is composed of solder metal powder kneaded with flux. The melting point of the solder paste is determined by the melting point of the solder powder, which is determined by the proportions in which materials contained, such as lead, tin, gallium, indium, etc., are mixed. The flux serves for removing oxide films from the surface of the metal to be soldered and for preventing oxidation of the solder during a soldering operation.

It is necessary to provide a variety of fluxes, suitable for a variety of solder powders. Flux includes an activator, which has the function of reducing and eliminating oxide film covering the surface of a region to be soldered. Usually, amine hydrogen halide is used, as an activator for liberating hydrogen halide by heat processing for soldering. Ordinarily, the activator cannot operate to a sufficient extent if it is applied in a small quantity, especially when the activator is used for low temperature soldering. Accordingly, diethylene amine hydrogen chloride of 0.3 weight percent of chlorine is usually added to the flux, but such an amount often causes deterioration of soldered portions.

If the solder paste is stored for a long time, its viscosity increases and becomes unsuitable for screen printing. Therefore, the present state-of-art solder paste has a shelf life (a limited period of time within which it should be used). The shelf life of ordinary high melting point solder paste is less than a week. However, the shelf life for low melting point solder paste becomes shorter as the melting point becomes lower. Solder paste having a melting point of 117°C, for example, which is suitable for soldering semiconductor chips, has a very short shelf life of only one day.

Short shelf life is a great inconvenience for practical use, and is a drawback for soldering procedures in printed circuit board manufacturing. Even within its shelf life period, solder paste having a short shelf life varies in its characteristics, such as hardness or viscosity for example, from hour to hour. Accordingly, handling and preservation of the solder paste must be performed very carefully. In many printed circuit board manufacturing workshops, the solder paste has to be prepared daily, and then kept under refrigeration to maintain as constant as possible the characteristics of the solder paste. Moreover, it is necessary to prepare various kinds of flux, suitable for each different melting point solder to be used. This is troublesome and time consuming.

Even when solder paste is carefully preserved, deviations of thickness of a silk screened pattern of solder paste often occur (and this is attributed to the variation of characteristics of the solder paste) and reliability of soldering is decreased. These problems are ascribed to the short shelf life of the solder paste.

GB-A-2 096 036 discloses a solder composition, for soldering components in electronic circuitry, comprising finely divided solder metal dispersed in a liquid vehicle containing a thixotropic agent, an organic solvent and a rosin flux. The particle size of the metal ranges from 40 to 70 $\mu$m. The solder metal is present in an amount of 86 to 87% by weight of the composition, and the liquid vehicle in an amount of 13 to 14% by weight.

It is disclosed that the liquid vehicle may contain components such as amine hydrochlorides, e.g. propylamine hydrochloride, hydroxyl substituted aliphatic amines, and aliphatic amines such as isopropyl amine, for example to remove surface oxides of the solder metals.

Reference is also made therein to a prior art solder composition comprising a vehicle containing an active chlorine-containing compound capable of removing surface oxides of solder metals.

According to the present invention there is provided a method of soldering an object, for example an electronic component, onto a substrate body, said method comprising the steps of :

preparing solder paste comprising solder flux and metal powder, said solder flux including amine hydrogen halide as an activator and an azobis compound as a free radical generator,

applying the solder paste to a metal layer portion of the substrate body,

positioning the object in contact with the solder paste, and

heating at least the solder pasted part of the metal portion and the electronic component whereby the azobis compound liberates hydrogen halide from said amine hydrogen halide and the liberated hydrogen halide removes oxide film from the soldering surfaces.

According to the present invention, there is provided a solder flux comprising amine hydrogen halide as an activator and an azobis compound as a free radical generator.

According to the present invention there is also provided a solder paste comprising such solder flux and solder alloy powder, the latter accounting for 85 to 90 weight percent of the total weight of the solder paste.

An embodiment of the present invention can provide for an extension of the shelf life of solder paste.

An embodiment of the present invention can provide a flux which is usable in solders offering a wide range of melting temperatures.

An embodiment of the present invention can provide for improved solderability of solder paste.

An embodiment of the present invention can provide for facilitation of the handling and preservation of solder paste.

An embodiment of the present invention can provide a low melting point solder paste suitable for soldering semiconductor chips on a printed circuit board.

An embodiment of the present invention can provide for an improvement in soldering flux, providing a flux which is applicable over a wide range of soldering temperatures, and can provide a low temperature solder paste suitable for mounting semiconductor chips.

In embodiments of the present invention a solder paste is used which includes a flux comprising rosin, thixotropic agent, and an activator consisting of amine hydrogen halide with organic solvent and an azobis compound as free radical generator, which liberates hydrogen halide from the activator.

Other radical generators can be considered, but in preferred embodiments of the present invention, 1,1'-azobis (cyclohexane-1-carbonitrile) is added to the flux as a radical generator. When the radical generator is heated during soldering, it generates free radicals of cyclohexane-1-carbonitrile. This free radical encourages liberation of hydrogen halide from the activator, and enhances the oxide film removal effect, providing for removal of oxide film over a metal surface to be soldered. Soldering at low temperature is facilitated because the hydrogen halide liberated by the free radicals increases more than with previously proposed fluxes. This enables the amount of activator to be reduced as compared with previously proposed solder pastes, and serves to prevent or reduce corrosion of soldered parts. Thus, the reliability at soldered parts is increased.

Moreover, the above flux as provided in an embodiment of the present invention can be applied to solders to afford a wide range of melting temperatures. Thus, the various solder pastes having various melting points can be prepared using the same flux.

Further, by adding 1,1'-azobis (cyclohexane-1-carbonitrile), it has been found that the shelf life of the solder paste is extended up to 20 days for low temperature solder paste. The use of solder paste in accordance with an embodiment of the present invention, therefore, serves to increase the quality and reliability of printed circuit boards.

Reference is made, by way of example, to the accompanying drawings, in which :

Fig. 1 is a block diagram illustrating a process of manufacture of a solder paste in accordance with an embodiment of the present invention,

Figs. 2(a) an 2(b) are schematic diagrams relating to chemical reaction of amine hydrogen chloride activator and 1,1'-azobis (cyclohexane-1-carbonitrile) free radical generator,

Fig. 3 is a graph giving experimental plots of solder paste wetting time against temperature, for respective fluxes including azobis and not including azobis,

Fig. 4 is a graph giving experimental plots of viscosity of solder pastes against time, and

Figs. 5(a) to 5(d) are schematic diagrams illustrating process steps for soldering IC chips and other components onto a printed circuit board using a low melting point solder paste and a high melting point solder paste in accordance with an embodiment of the present invention.

Generally, solders of different melting points are obtained by varying the metals mixed in the solders. Though low melting point solders can be provided, they cannot be used directly for soldering, because it is necessary to remove oxide film formed on the surface of a soldering region, and to protect the surface from oxidation during the soldering.

Therefore, it is most important to provide a proper flux suitable for the desired soldering temperature. In the present state-of-the-art technology, flux loses activity as soldering temperature decreases. It is therefore difficult, with this state-of-the-art technology, to realize soldering at low temperature in air.

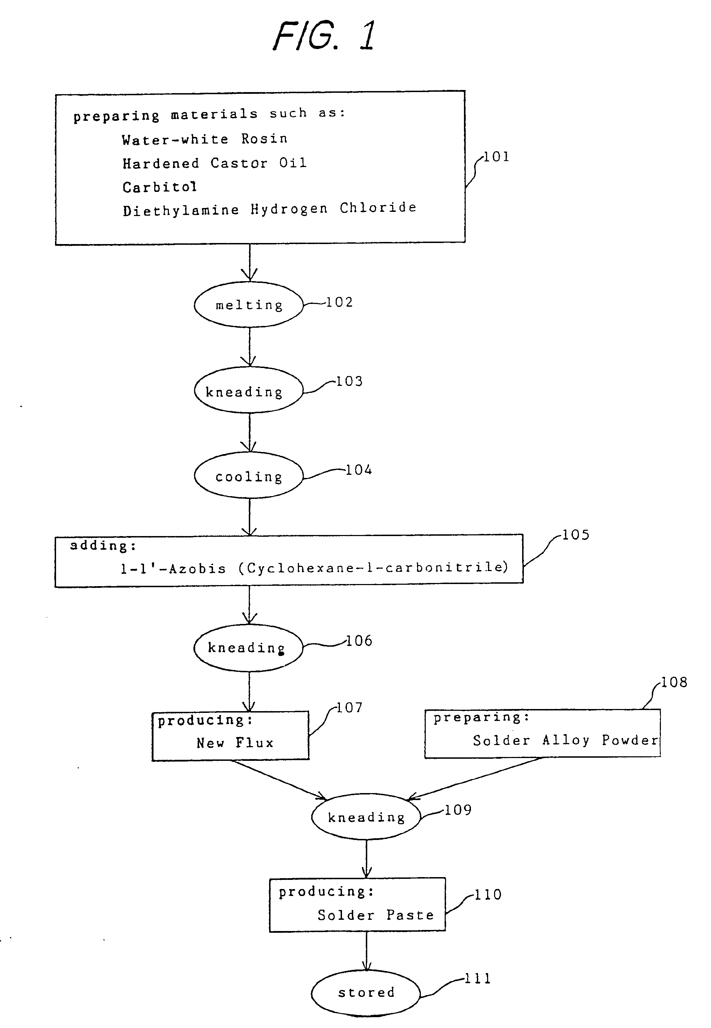

Fig. 1 illustrates a process for preparing solder paste in accordance with an embodiment of the present invention. In the following description, numerals in brackets correspond to the reference numerals used in Fig. 1. First, flux material (101) that is a mixture of water-white rosin, hardened castor oil, carbitol and diethylamine hydrogen chloride are put into a crucible. These are all conventional ingredients used for preparing ordinary solder flux. An example of proportions in which the ingredients are mixed is as follows :

| water-white rosin | 52 |
| hardened castor oil | 2 |
| carbitol | 35 and |
| diethylamine hydrogen chloride | 1 in Wt% |

(weight percent), respectively. Then, the ingredients are heated and melted (102) at a temperature of 80°C, for example. When they are melted, they are kneaded (103) by a kneader to form a paste.

In this example, carbitol (of 35 part) is added as solvent to the water-white rosin (of 52 part), the hardened castor oil (of 2 part) is added as thixotropic agent. These relative amounts of these components of the flux may be varied to some extent : for example, the amount of rosin may vary from 45% to 75%, castor oil may be present in an amount less than (up to) 5%, diethylamine hydrogen chloride may be present in an amount less than (up to) 3% and the amount of carbitol may vary from 15% to 55% (balance weight percent of other contents of the flux). As activator, diethylamine or triethylamine hydrogen chloride is useful.

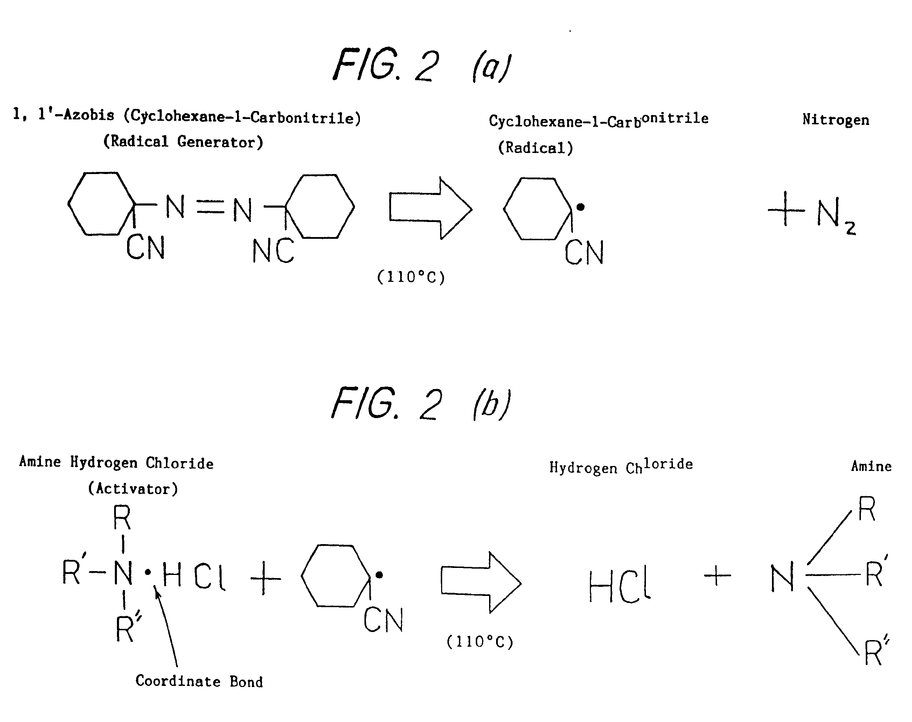

A most important feature of the present invention is to add an azobis compound as a free radical generator. In this example, 10 Wt% of 1,1'-azobis (cyclohexane-1-carbonitrile) is added. The relative amount of this component of the flux may also be varied, for example from 1 to 20 Wt%. This free radical generator material will be called "azobis" hereinafter, for the sake of simplicity. Its chemical structure is illustrated in Fig. 2(a). After cooling (104) down to room temperature, azobis is added (105) to the flux paste prepared in the manner described above. The paste is kneaded (106) again to form a new flux (107).

Then, solder alloy powder (108) having a grain size between 44 µm and 74 µm (of 200-325 mesh) and having desired melting point is added, and the result kneaded (109) again. The amount of solder powder in the complete solder paste may be 88 Wt%, for example. Thus, a solder paste (110) embodying the present invention is prepared. The solder paste can be stored (111) until it is used. The solder paste described above is suitable for silk screen printing. However, the hardness or viscosity of solder paste embodying the present invention can be varied by varying the proportions in which ingredients are mixed. It will therefore be clear that it is possible to provide solder pastes suitable for other kinds of application.

It has been found that above-described flux can be used in solder pastes offering a wide range of soldering temperatures. Thus, only one flux is needed for preparing various kinds of solder paste, having different melting points. This is a great merit of the flux provided by embodiments of the present invention, in comparison with previous solder fluxes.

As mentioned above, the melting point of a solder is varied by varying the metals chosen to make up the solder, and/or the proportions in which the metals are mixed. This is well known in the art, and since it is not explicitly related to the present invention, further description is omitted for the sake of simplicity.

Figs. 2(a) and 2(b) illustrate chemical reactions which are believed to occur in a flux embodying the present invention during a soldering operation. The azobis added to the flux operates as a radical generator. When heated to more than 110°C, the azobis generates free radicals of cyclohexane-1-carbonitrile as indicated in Fig. 2(a). This radical will be referred to hereinafter simply as "radical" or "free radical". The quantity of the free radical generator azobis is not critical, but when it exceeds 10 weight percent in total amount of flux, the amount of generated nitrogen may become excessive and thereby wetability of the solder may be poor.

Generally, amine hydrogen chloride is an activator which liberates hydrogen chloride (HCl) when it is heated. The liberated hydrogen chloride removes oxide film from the surface of a region to be soldered. The degree to which hydrogen chloride is liberated decreases as temperature decreases. This is a reason why previous fluxes loose activity when used for low temperature soldering. However, as shown in Fig. 2(b) when azobis is added the free radicals generated from the azobis serve to break the coordinate bond between amine and the hydrogen chloride. So, the liberation of hydrogen chloride from the activator is enhanced. Considerable amounts of hydrogen chloride are generated even at low temperature, and hence, the activity of the flux is not decreased when it is used for low temperature soldering.

The beliefs set forth above are supported by following experiments. The wetting time of solder pastes at various temperatures, was measured with a meniscograph. For the measurements, one end of a predetermined sized copper ribbon was vertically immersed into a melted solder. At first the solder surface dips down, at the surface of the ribbon, due to surface tension. Soon, however, the surface of the solder begins to rise along the ribbon, wetting its surface. Finally, the level of the solder on the side wall of the ribbon creeps up higher than the surface of the solder. Wetting time is determined as the time period between the moment at which the ribbon is dipped into the solder and the moment at which the level of the solder on the ribbon again reaches the level (the general level) of the solder surface

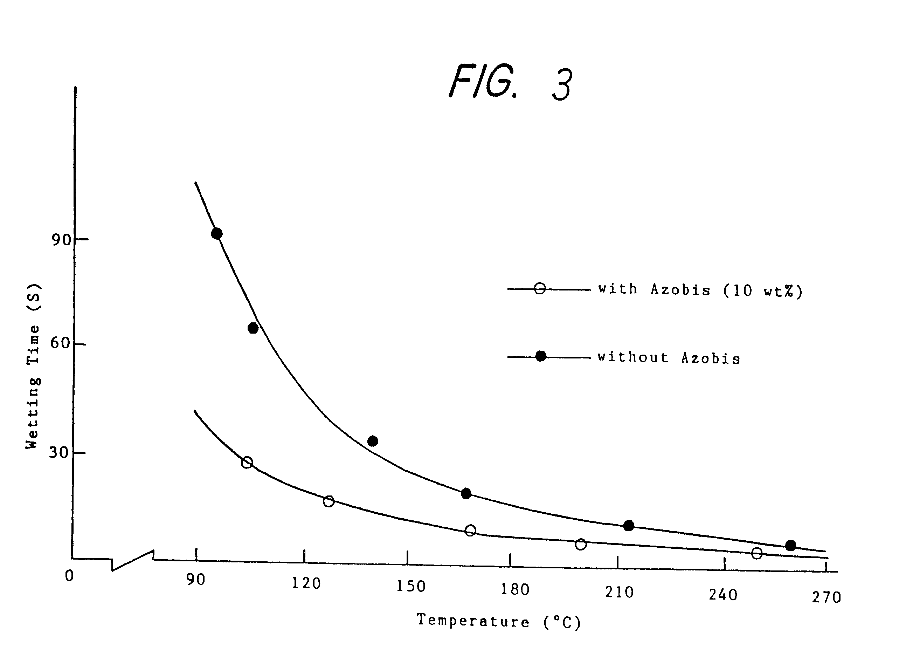

Fig. 3 is a graph showing experimental results which serve for comparison of the activity of a flux which includes the azobis with the activity of a flux which does not include azobis. In the graph, the ordinate indicates wetting time in seconds, and the abscissa indicates temperature (during soldering) in °C. The curves connecting solid circles relate to data for flux without azobis the curves connecting white circles (rings) relate to data for flux with azobis.

As can be seen from Fig. 3, wetting time decreases as temperature increases for both fluxes including azobis and not including azobis. This is assumed to occur because liberation of hydrogen chloride increases as temperature increases. However, as temperature goes down, the activity of the flux without azobis (solid circles) decreases rapidly. On the other hand, the flux with azobis (white circles) maintains its activity at a higher level than the flux without azobis. This means that the flux including azobis as a radical generator is usable for lower temperatures than is the flux which does not include azobis. The flux in accordance with an embodiment of the present invention, therefore, is capable of forming low melting point solder pastes such as a paste including In-Sn alloy solder.

Fig. 3 also indicates, if the two solder pastes are compared to each other at the same temperature, that the solder paste including azobis has a higher wetability than the solder paste which does not include azobis, because the wetting time of the solder paste including azobis is smaller than that of the solder paste which does not include azobis.

As mentioned above, the viscosity of previous art solder paste varies with time, and this is particularly manifest for low melting point solder paste. This variation can give rise to decreased and reproducibility of thickness of solder paste coating a soldering area, reduced wetability of solder, and decreased reliability of soldering. However, it has been found that, when azobis radical generator is added into the solder flux, the solder paste is not hardened even after storing for six months.

This means that the shelf life of solder paste in accordance with an embodiment of the present invention is extended to a considerable degree. Therefore, solder paste in accordance with an embodiment of the present invention is suitable for screen printing with an assurance of high reliability of soldered parts.

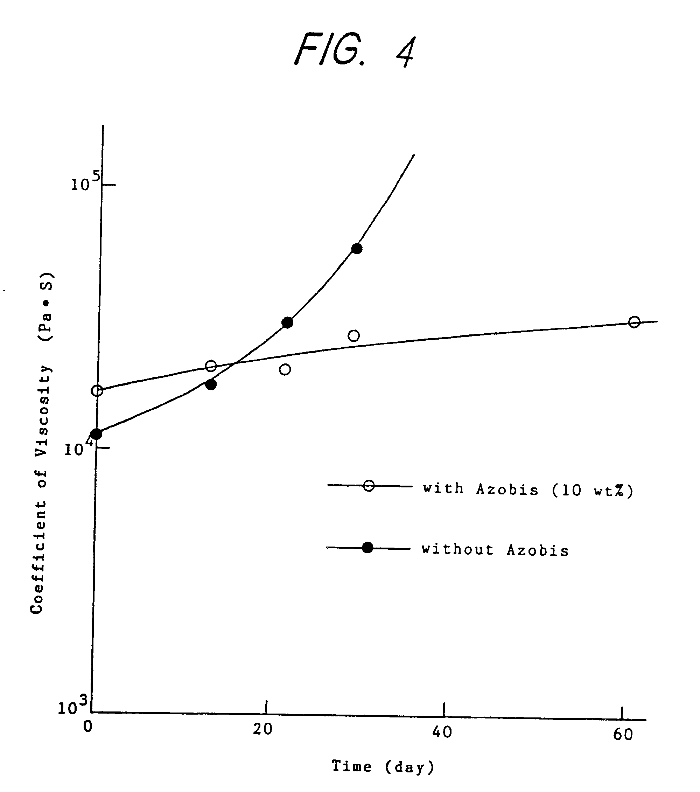

In the graph of Fig. 4, changes of viscosity soldering pastes with time are illustrated. In the graph, the curve connecting solid circles indicates the variation of viscosity of a previous solder paste which does not include azobis. The curve connecting white circles (rings) illustrates the variation of viscosity of a solder paste in accordance with an embodiment of the present invention. As can be seen in the graph, the viscosity of the solder paste comprising azobis radical generator hardly changes over a period of a few months, whilst the viscosity of the previous solder pastes varies over a very short period.

Japanese Patent No. 56-32079 discloses a solder flux using an organic compound including an unstable atomic radical as an activator. In this solder flux, as in the case of conventional activator, the activator serves to liberate halogen atoms at soldering temperature, and the liberated halogen atoms serve to reduce and remove oxide film. The liberation of the halogen atoms is encouraged by increased temperature, whilst the generation of halogen atoms and hence the activity of the flux is decreased when temperature is decreased.

However, operation of a flux in accordance with an embodiment of the present invention is suspected to be as follows. The radical generator employed in an embodiment of the present invention does not function as an activator, but it exhibits the characteristic of generating hydrogen halide when it meets amine hydrogen halide. Namely, the radical generator generates free radicals when it is heated up to soldering temperature. The free radical contributes to break the coordinate bond between amine and hydrogen halide included in the activator. This results in reduction of oxide film. Therefore, the activation of the activator is not directly driven by temperature, but it is accelerated by the increase of free radicals. The decrease in the amount of free radicals provided from the radical generator is not so great compared to the decrease of liberated halogen atoms from the activator when the temperature is decreased. Thus, the activity of flux in accordance with an embodiment of the present invention is maintained to a lower temperature than that of a previous flux.

The above is but an assumption or suspicion. However, regardless of the correct theoretical explanation therefor, solder paste in accordance with an embodiment of the present invention exhibits superior properties as compared with any other flux or solder paste.

The activator is enhanced in its effect by free radicals generated by the radical generator to an extent more than it is activated by temperature. Therefore, the quantity of activator to be included in the flux can be reduced. This provides the additional effect of preventing or reducing erosion of soldered parts by remaining activator. So the reliability of soldered parts is increased. Moreover, azobis is a stable compound at normal temperature, so the characteristics of the flux in accordance with an embodiment of the present invention is stable, and hence shelf life is extended.

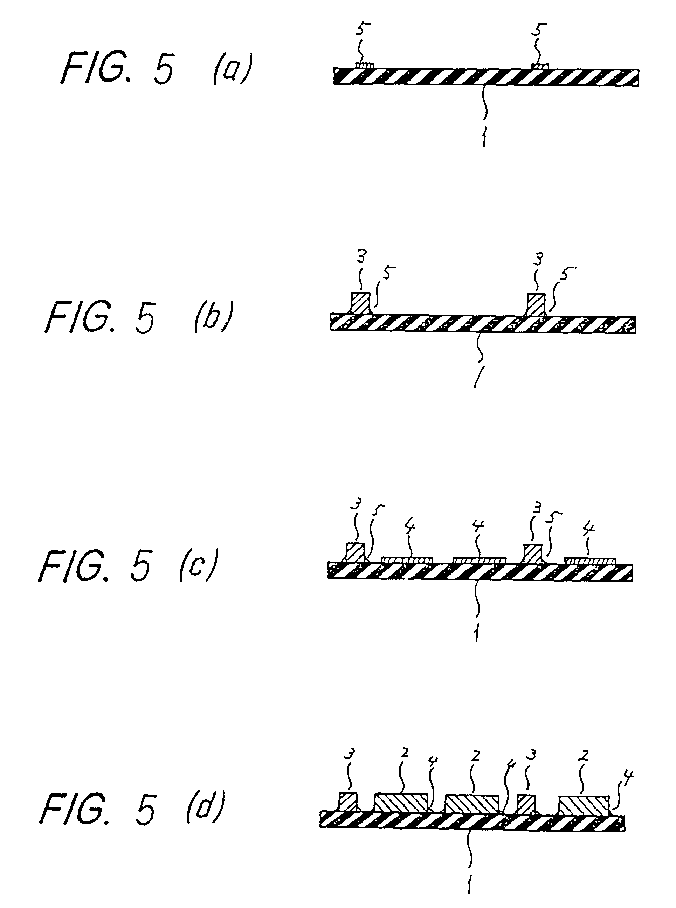

Next, a method of step soldering which is applicable to printed circuit board fabrication will be described briefly. Figs. 5(a) to 5(d) are schematic cross sectional views illustrating the process steps for the step soldering.

First, a first solder paste which has a relatively high melting point of 183°C, for example, prepared by a method as described above, is used. As shown in Fig. 5(a), a pattern 5 of solder paste is formed on the surface of a printed circuit board 1 at portions where electronic devices are to be soldered. Silk screen printing is applicable for the patterning of the solder paste.

Next, as shown in Fig. 5(b), first electronic circuit components 3 which can be soldered at relatively high temperature, such as chip capacitors or resistors, are placed in position for soldering. This can be done using an ordinary loading machine. Then, the printed circuit board is heated at 215°C, for example, in an oven, to solder the circuit elements.

Then, as shown in Fig. 5(c), patterns 4 of a second solder paste which has a relatively low melting point of 117°C, for example, are formed at portions where second electronic components which cannot be heated up to so high a temperature, such as semiconductor device chips, are to be soldered. In this case, chalcography printing, for example, is applicable.

Then, the second electronic components 2 are placed in position by loading machine. The printed circuit board is again heated in an oven, to a relatively low temperature, 155°C, for example, and the second electronic components 2 are soldered as shown in Fig. 5(d). In this process, the first electronic components 3 which were soldered previously are not harmed, because the melting point of the solder for them is higher than that of the second electronic components.

In such a manner, the printed circuit board is completed. In the above description, silk screen printing and chalcography printing are used for forming the patterns for the first and second solder paste. It will be clear that any other patterning method, such as thin film circuit technology, can be applied to form the solder paste pattern.

The materials used in the above-described embodiments of the invention, such as hydrogen chloride in amine hydrogen chloride activator may be replaced by similar materials such as hydrogen bromide, etc. The embodiments disclosed above are, therefore, to be considered in all respects as illustrative and not restrictive. Embodiments of the present invention provide or use solder paste which comprises azobis as a free radical generator in the flux.

As have been described above, by the use of the solder paste in accordance with an embodiment of the present invention, the soldering of electronic components onto a printed circuit board is facilitated. In the above-described step soldering, only two kinds of solder pastes are used. However, it will be apparent, any other kinds of solder paste having appropriate melting points for the components to be soldered can be used. The application of the solder pastes embodying the present invention is not limited to printed circuit boards, and the method of applying solder paste to a soldering region is not limited to silk screen printing : for example various painting methods, including painting by brush, can be used. The heating method used soldering may be modified in various ways, for example as for dip soldering or vapour phase soldering in which the circuit board is immersed in fluorocarbon gas heated to appropriate temperature.

An embodiment of the present invention provides a soldering method using a solder paste composed of solder alloy powder and soldering flux comprising rosin, thixotropic agent, activator, organic solvent and an azobis compound such as 1,1'-azobis (cyclohexane-1-carbonitrile) as a free radical generator. The 1,1'-azobis (cyclohexane-1-carbonitrile) generates free radicals of cyclohexane-1-carbonitrile when heated in soldering, and the generated free radicals urge the activator to liberate hydrogen halide which enhances ability to remove oxide film from a metal surface to be soldered. The azobis compound allows the amount of activator used to be reduced and, consequently, allows the amount of hydrogen halide in the flux to be reduced. The viscosity of the solder paste does not vary for a long time, so that the solder paste has a long shelf life. Since generation of the free radical is not decreased even when soldering temperature decreased, increased solderability at low temperature is provided.

## Claims

1. A method of soldering an object, for example an electronic component, onto a substrate body, said method comprising the steps of :

    preparing solder paste comprising solder flux and metal powder, said solder flux including amine hydrogen halide as an activator and an azobis compound as a free radical generator,

    applying the solder paste to a metal layer portion of the substrate body,

    positioning the object in contact with the solder paste, and

    heating at least the solder pasted part of the metal portion and the electronic component whereby the azobis compound liberates hydrogen halide from said amine hydrogen halide and the liberated hydrogen halide removes oxide film from the soldering surfaces.

2. A method according to claim 1, wherein said azobis compound is 1,1'-azobis (cyclohexane-1-carbonitrile), the amount of which, in the total weight of the soldering flux, is 1 to 20 in weight percent, and the soldering

6

flux further comprises 45 to 75 weight percent water-white rosin, up to 5 weight percent hardened castor oil, up to 3 weight percent diethylamine hydrogen halide, and 15 to 55 percent carbitol.

3. A method according to claim 1 or 2, wherein the metal powder comprises powder of tin-lead alloy comprised of 62 weight percent tin and 38 weight percent lead, having a grain size between 44 μm and 74 μm (a mesh of from 200 to 325) and a melting point of 183°C.

4. A method according to claim 1 or 2, wherein the metal powder comprises powder of indium-lead alloy, comprised of 52 weight percent indium and 48 weight percent lead, having a grain size between 44 μm and 74 μm (a mesh of from 200 to 325) and a melting point of 117°C.

5. A method according to any preceding claim, wherein the solder paste comprises the metal powder concerned as 85 to 90 weight percent of the total weight of the solder paste.

6. A method according to any preceding claim, wherein the application of solder paste to a soldering region is accomplished by silk screen printing and/or chalcography printing.

7. A solder flux comprising amine hydrogen halide as an activator and an azobis compound as a free radical generator.

8. A solder flux as claimed in claim 7, wherein the azobis compound is 1,1'-azobis (cyclohexane-1-carbonitrile).

9. A solder flux as claimed in claim 7 or 8, comprising 1 to 20 weight percent the azobis compound, less than 3 weight percent amine hydrogen halide as activator, 45 to 75 weight percent water-white rosin, less than 5 weight percent hardened castor oil and 15 to 55 weight percent carbitol.

10. A solder paste comprising solder flux as claimed in claim 7, 8 or 9, and solder alloy powder, the latter accounting for 85 to 90 weight percent of the total weight of the solder paste.

## Ansprüche

1. Verfahren zum Löten eines Objektes, z.B. einer elektronischen Komponente, auf einen Substratkörper, welches Verfahren die folgenden Schritte umfaßt :

Vorbereiten einer Lötpaste, die ein Lötflußmittel und Metallpulver umfaßt, welches genannte Lötflußmittel Aminwasserstoffhalogenid als einen Aktivator und eine Azobis-Verbindung als Generator freier Radikaler umfaßt,

Anwenden der Lötpaste auf einen Metallschichtabschnitt des Substratkörpers,

Positionieren des Objektes in Kontakt mit der Lötpaste, und

Erhitzen wenigstens des mit Lötpaste versehenen Teils des Metallabschnittes und der elektronischen Komponente, wodurch die Azobis-Verbindung Wasserstoffhalogenid von dem genannten Aminwasserstoffhalogenid befreit und das befreite Wasserstoffhalogenid Oxidfilm von den Lötflächen entfernt.

2. Verfahren nach Anspruch 1, bei dem die genannte Azobis-Verbindung 1,1'-Azobis-(Cyclohexan-1-Carbo-Nitril) ist, dessen Betrag, in dem Gesamtgewicht des Lötflußmittels, 1 bis 20 Gewichtsprozent ist, und das Lötflußmittel ferner 45 bis 75 Gewichtsprozent wasserweißes Kolophonium, bis zu 5 Gewichtsprozent gehärtetes Rizinusöl, bis zu 3 Gewichtsprozent Diethylaminwasserstoffhalogenid und 15 bis 55 Gewichtsprozent Carbitol enthält.

3. Verfahren nach Anspruch 1 oder 2, bei dem das Metallpulver Pulver von einer Zinn-Blei-Legierung umfaßt, welches aus 62 Gewichtsprozent Zinn und 38 Gewichtsprozent Blei besteht, eine Korngröße zwischen 44 μm und 74 μm (eine Maschenweite von 200 bis 325) und einen Schmelzpunkt von 183°C hat.

4. Verfahren nach Anspruch 1 oder 2, bei dem das Metallpulver Pulver von einer Indium-Blei-Legierung umfaßt, welches aus 52 Gewichtsprozent Indium und 48 Gewichtsprozent Blei besteht, eine Korngröße zwischen 44 μm und 74 μm (eine Maschenweite von 200 bis 325) und einen Schmelzpunkt von 117°C hat.

5. Verfahren nach einem der vorhergehenden Ansprüche, bei dem die genannte Lötpaste das Metallpulver umfaßt, welches mit 85 bis 90 Gewichtsprozent an dem Gesamtgewicht der Lötpaste beteiligt ist.

6. Verfahren nach einem der vorhergehenden Ansprüche, bei dem die Anwendung der Lötpaste auf einen Lötbereich durch Seidensiebdrucken und/oder chalcographisches Drucken erreicht wird.

7. Lötflußmittel mit Aminwasserstoffhalogenid als einem Aktivator und eine Azobis-Verbindung als einen Generator für freie Radikale.

8. Lötflußmittel nach Anspruch 7, bei dem die AzobisVerbindung ein 1,1'-Azobis-(Cyclohexan-1-Carbo-Nitril) ist.

9. Lötflußmittel nach Anspruch 7 oder 8, mit 1 bis 20 Gewichtsprozent der Azobis-Verbindung, weniger als 3 Gewichtsprozent Aminwasserstoffhalogenid als Aktivator, 45 bis 75 Gewichtsprozent wasserweißem Kolophonium, weniger als 5 Gewichtsprozent gehärtetem Rizinusöl und 15 bis 55 Gewichtsprozent Carbitol.

10. Lötpaste mit einem Lötflußmittel nach Anspruch 7, 8 oder 9, und mit Lötlegierungspulver, welch letzteres 85 bis 90 Gewichtsprozent des Gesamtgewichtes der Lötpaste beträgt.

**Revendications**

1. Une méthode de brasage d'un objet, par exemple d'un composant électronique, sur un substrat, ladite méthode comprenant les étapes suivantes :

préparation d'une pâte à braser comprenant un flux de brasage et une poudre métallique, ledit flux de brasage incluant un halogénhydrate d'amine comme activateur et un composé azobis comme générateur de radicaux libres,

application de la pâte à braser sur une portion d'une couche métallique du substrat,

positionnement de l'objet en contact avec la pâte à braser, et

chauffage d'au moins la partie munie de la pâte à braser de la portion métallique et du composant électronique de façon que le composé azobis libère l'acide halogénhydrique dudit halogénhydrate d'amine et que l'acide halogénhydrique libéré élimine le film d'oxyde des surfaces à braser.

2. Une méthode selon la revendication 1, selon laquelle ledit composé azobis est le 1,1'-azobis (cyclohexane-1-carbonitrile) dont la quantité, dans le poids total du flux de brasage, est de 1 à 20% en poids, et le flux de brasage comprend encore 45 à 75% en poids de résine transparente, jusqu'à 5% en poids d'huile de ricin durcie, jusqu'à 3% en poids d'halogénhydrate de diéthylamine, et 15 à 55% de carbitol.

3. Une méthode selon la revendication 1 ou 2, selon laquelle la poudre métallique comprend une poudre d'alliage d'étain-plomb composée de 62% en poids d'étain et de 38% en poids de plomb, ayant une taille de grains comprise entre 44 µm et 74 µm (200 à 325 mesh) et un point de fusion de 183°C.

4. Une méthode selon la revendication 1 ou 2, selon laquelle la poudre métallique comprend une poudre d'alliage d'indium-plomb, composée de 52% en poids d'indium et de 48% en poids de plomb, ayant une taille de grains comprise entre 44 µm et 74 µm (200 à 325 mesh) et un point de fusion de 117°C.

5. Une méthode selon l'une quelconque des revendications précédentes, selon laquelle la pâte à braser comprend la poudre métallique concernée en quantité de 85 à 90% en poids du poids total de la pâte à braser.

6. Une méthode selon l'une quelconque des revendications précédentes, selon laquelle l'application de la pâte à braser sur une région de brasage est réalisée par impression par sérigraphie et/ou impression par chalcographie.

7. Un flux de brasage comprenant un halogénhydrate d'amine comme activateur et un composé azobis comme générateur de radicaux libres.

8. Un flux de brasage selon la revendication 7, selon lequel le composé azobis est le 1,1'-azobis (cyclohexane-1-carbonitrile).

9. Un flux selon le brasage selon la revendication 7 ou 8, comprenant 1 à 20% en poids de composé azobis, moins de 3% en poids d'halogénhydrate d'amine comme activateur, 45 à 75% en poids de résine transparente, moins de 5% en poids d'huile de ricin durcie et 15 à 55% en poids de carbitol.

10. Une pâte à braser comprenant un flux de brasage selon la revendication 7, 8 ou 9, et une poudre d'alliage de brasage, cette dernière étant en quantité de 85 à 90% en poids du poids total de la pâte à braser.

# FIG. 1

```
preparing materials such as:
      Water-white Rosin
      Hardened Castor Oil
      Carbitol
      Diethylamine Hydrogen Chloride
```
— 101

( melting ) — 102

( kneading ) — 103

( cooling ) — 104

```
adding:
      1-1'-Azobis (Cyclohexane-1-carbonitrile)
```
— 105

( kneading ) — 106

```
producing:
      New Flux
```
— 107

```
preparing:
      Solder Alloy Powder
```
— 108

( kneading ) — 109

```
producing:
      Solder Paste
```
— 110

( stored ) — 111

## FIG. 2 (a)

1, 1'-Azobis (Cyclohexane-1-Carbonitrile)
(Radical Generator)

Cyclohexane-1-Carbonitrile
(Radical)

Nitrogen

(110°C)

## FIG. 2 (b)

Amine Hydrogen Chloride
(Activator)

Hydrogen Chloride

Amine

(110°C)

Coordinate Bond

EP 0 264 939 B1

FIG. 3

EP 0 264 939 B1

FIG. 4

FIG. 5 (a)

FIG. 5 (b)

FIG. 5 (c)

FIG. 5 (d)